# EUROPEAN PATENT APPLICATION

(11) **EP 2 778 590 A2**
(43) Date of publication of application: **17.09.2014**
(21) Application number: 14156769.3
(22) Date of filing: 26.02.2014
(51) Int. Cl.: F28D 15/02, F28D 1/02, H01L 23/427, H05K 7/20

(54) **Two-phase cooling system**

(30) Priority: 15.03.2013 US 201313835770
(71) Applicant: Parker-Hannifin Corporation, Cleveland, Ohio 44124-4141 (US)
(72) Inventor: Wegmann, Brandon Joseph, Fort Wayne, IN 46804 (US); O'Shaughnessey, Stephen John, Monroeville, IN 46773 (US)
(74) Representative: Belcher, Simon James

(57) **Abstract**

A modular pumped loop cooling apparatus includes a cooling module that rejects heat absorbed by a two-phase fluid entering the cooling module and that condenses the two-phase fluid to a liquid. A pumping module receives the liquid from the cooling module and pumps the liquid to a heat sink. The pumping module has an inlet coupling for mating with a corresponding outlet coupling of the cooling module when the cooling module is placed on top of the pumping module.

## Description

The present invention relates generally to cooling systems, and more particularly to pumped liquid cooling systems.

Power electronic devices, such as IGBTs, SCRs, etc., can achieve high power switching capacity in a small envelope. However, the power electronic devices generate heat during operation, and therefore a cooling system is used to cool the power electronic devices. For example, air may be blown over the power electronic devices or a water-based fluid may be circulated through a cold plate coupled to the power electronic devices to cool the devices.

The present invention provides a modular pumped loop cooling apparatus including a cooling module and a pumping module, wherein the pumping module has an inlet coupling for mating with a corresponding outlet coupling of the cooling module when the cooling module is placed on top of the pumping module. The modular pumped loop cooling apparatus is provided as a standalone unit that can be coupled to any one of a plurality of heat sinks having different heat loads. The cooling apparatus is therefore scalable to accommodate a wide range of cooling applications so that the apparatus does not have to be redesigned to accommodate a particular system.

The invention provides a modular pumped loop cooling apparatus which includes a cooling module that rejects heat absorbed by a two-phase fluid entering the cooling module and that condenses the two-phase fluid to a liquid, and a pumping module that receives the liquid from the cooling module and pumps the liquid to a heat sink, wherein the pumping module has an inlet coupling for mating with a corresponding outlet coupling of the cooling module when the cooling module is placed on top of the pumping module.

Optionally, the couplings mate with one another automatically during placement of the cooling module on top of the pumping module.

Optionally, the cooling module includes an inlet portion for connecting to the heat sink and the pumping module includes an outlet portion for connecting to the heat sink.

Optionally, the cooling module defines a cooling portion of a loop and the pumping module defines a pumping portion of the loop, and wherein the loop is completed by the heat sink.

Optionally, the cooling module includes a housing and a condenser assembly disposed in the housing, the condenser assembly including an inlet conduit and an inlet coupling for connecting to the heat sink and an outlet conduit and the outlet coupling.

Optionally, the pumping module includes a reservoir having an inlet conduit and the inlet coupling that mates with the outlet coupling of the cooling module, a pump fluidically coupled to the reservoir and including an outlet conduit and an outlet coupling for connecting to the heat sink, and a housing that houses the reservoir and the pump.

Optionally, the housing has a base portion, a plurality of support portions extending from the base portion, and a plurality of side portions coupled to the support portions, and wherein a plurality of brackets are coupled to the base portion for supporting the reservoir and the pump.

Optionally, one of the plurality of side portions includes an opening through which the outlet coupling coupled to the pump outlet conduit extends.

Optionally, the condenser assembly includes a condenser that condenses the two-phase fluid and a fan that rejects the heat.

Optionally, the fan extends through an opening in the housing on top of the housing and is configured to draw air into a plurality of sides of the housing to cool the two-phase fluid in the condenser and reject the heat to an environment outside of the housing.

Optionally, the plurality of sides of the housing have perforations for allowing the air to be drawn into the housing and blown over corresponding sides of the condenser.

Optionally, one of the plurality of side portions includes an opening through which the inlet coupling of the condenser assembly extends.

Optionally, the housing and condenser are substantially rectangular in shape.

Optionally, the condenser assembly includes a condenser that condenses the two-phase fluid and a liquid cooling assembly for passing liquid across the condenser to cool the fluid.

Optionally, the pumped loop cooling apparatus may be provided in combination with any one of a plurality of heat sinks having different heat loads and being configured to be in thermal contact with a heat source, wherein the cooling module includes an inlet portion connected to one of the plurality of heat sinks and the pumping module includes an outlet portion connected to one of the plurality of heat sink.

The invention also provides a modular pumped loop apparatus configured to be coupled to a heat sink, the apparatus including a cooling module including a housing and a condenser assembly disposed in the housing and including an inlet conduit coupled and an inlet coupling for connecting to the heat sink and an outlet conduit and an outlet coupling, the condenser assembly being configured to reject heat absorbed by a two-phase fluid that enters the condenser assembly through the inlet conduit and condense the two-phase fluid to a liquid, and a pumping module configured to be coupled to the cooling module, the pumping module including a reservoir having an inlet conduit and an inlet coupling for mating with the outlet coupling of the condenser assembly to receive the liquid from the condenser assembly, a pump fluidically coupled to the reservoir for receiving the liquid and including an outlet conduit and an outlet coupling for connecting to the heat sink, and a housing that houses the reservoir and the pump.

Optionally, the condenser assembly includes a condenser that condenses the two-phase fluid and one of a fan or a liquid cooling assembly for rejecting heat from the fluid.

Optionally, the inlet coupling of the pumping module mates with the outlet coupling of the cooling module when the cooling module is placed on top of the pumping module.

Optionally, the pumped loop cooling apparatus may be provided in combination with any one of a plurality of heat sinks having different heat loads and being configured to be in thermal contact with a heat source, wherein the cooling module includes an inlet portion connected to one of the plurality of heat sinks and the pumping module includes an outlet portion connected to one of the plurality of heat sink.

The invention also provides a method of assembling a pumped loop cooling apparatus which includes providing a cooling module having an input mating coupling for connecting to a first mating coupling on any one of a plurality of heat sinks having different heat loads, providing a pumping module having an output mating coupling for connecting to a second mating coupling on any one of the plurality of heat sinks, and placing the cooling module on top of the pumping module such that an output mating coupling of the cooling module mates with a corresponding input mating coupling of the pumping module to fluidly couple the cooling module and the pumping module.

The invention is described below by way of example with reference to the accompanying drawings, in which
Fig. 1 is a schematic representation of a modular pumped loop cooling system.
Fig. 2 is a perspective view of a modular pumped loop cooling apparatus of the system.
Fig. 3 is a top view of the modular pumped loop cooling apparatus.
Fig. 4 is a left side view of the modular pumped loop cooling apparatus.
Fig. 5 is a front view of the modular pumped loop cooling apparatus.
Fig. 6 is a perspective view of an exemplary cooling module of the modular pumped loop cooling apparatus with side portions removed.
Fig. 7 is a top view of the cooling module.
Fig. 8 is a front view of the cooling module.
Fig. 9 is a left side view of the cooling module.
Fig. 10 is another perspective view of the cooling module.
Fig. 11 is a top perspective view of the cooling module.
Fig. 12 is a perspective view of an exemplary condenser of the cooling module.
Fig. 13 is a perspective view of an exemplary pumping module with side portions removed.
Fig. 14 is a perspective view of an exemplary housing of the pumping module.
Fig. 15 is a top view of the housing.
Fig. 16 is a perspective view of an exemplary filter dryer and relief valve of the pumping module.
Fig. 17 is a perspective view of an exemplary reservoir, strainer and ball valve of the pumping module.
Fig. 18 is a side view of the reservoir, strainer and ball valve.

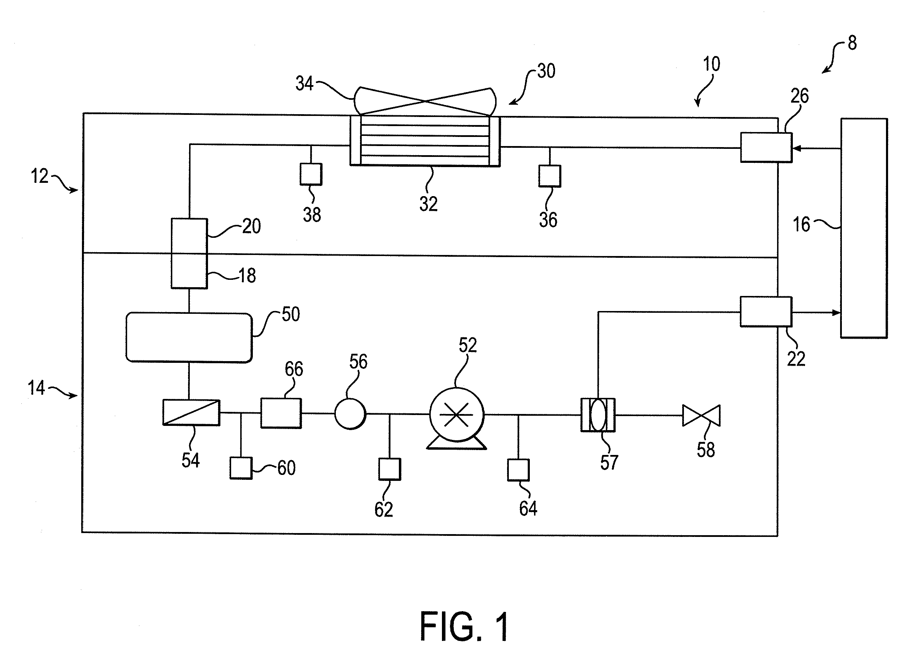

Turning now in detail to the drawings, Fig. 1 is a schematic representation of a modular pumped loop cooling system 8 which includes a modular pump loop cooling apparatus 10 including a cooling module 12 defining a cooling portion of a loop, a pumping module 14 defining a pumping portion of the loop, and a heat exchanger 16, such as a heat sink or cold plate completes the loop. The pumping module 14 has an inlet portion, such as inlet coupling 18 for mating with a corresponding outlet portion, such as outlet coupling 20 of the cooling module 12 when the cooling module is placed on top of the pumping module 14. Alternatively, it will be appreciated that the cooling module 12 and pumping modules 14 may be oriented in other suitable orientations, such as a side by side orientation. The inlet and outlet couplings 18 and 20 may be male/female couplings that mate with one another automatically during placement of the cooling module 12 on top of the pumping module 14, may be couplings that are coupled in another suitable way, such as by manually threading the couplings, etc. The pumping module 14 also has an outlet portion, such as an outlet coupling 22 for connecting to the heat sink 16, which is in thermal contact with a heat source for absorbing heat from the source. The cooling module 12 also has an inlet portion, such as an inlet coupling 26 for connecting to the heat sink 16.

The cooling module 12 is provided to reject heat absorbed by a two-phase fluid, such as a two-phase refrigerant, entering the cooling module and to condense the two-phase fluid to a liquid. To do so, the cooling module 12 includes a condenser assembly 30 downstream of the inlet coupling 26. In an embodiment, the condenser assembly 30 includes a condenser 32 that condenses the two-phase fluid and a fan 34 that rejects the heat from the two-phase fluid. Alternatively, the condenser assembly 30 may include the condenser 32 and a liquid cooling assembly (not shown), such as a water cooling assembly, for passing liquid across the condenser 32 to cool the two-phase fluid. The cooling module 12 also includes charge ports 36 and 38 upstream and downstream of the cooling module 12, respectively, for gauging system pressure, evacuating the system, and/or adding fluid to the system.

The pumping module 14 is provided to receive the liquid from the cooling module 12 and to pump the liquid to the heat sink 16. To do so, the pumping module includes a reservoir 50 that is fluidically coupled to the condenser 32 for receiving the cooled liquid, and a pump 52 that is fluidically coupled to the reservoir 50 and configured to pump the liquid to the outlet coupling 22. The pumping module also includes a strainer 54 for filtering debris, a sight glass 56 for checking if the pump is cavitating, a filter dryer 57 for removing moisture, a pressure relief valve 58 for relieving pressure above a predetermined amount, charge port 60 between the strainer and ball valve, charge ports 62 and 64 upstream and downstream of the pump 52, and the ball valve 66 between the charge ports 60 and 62.

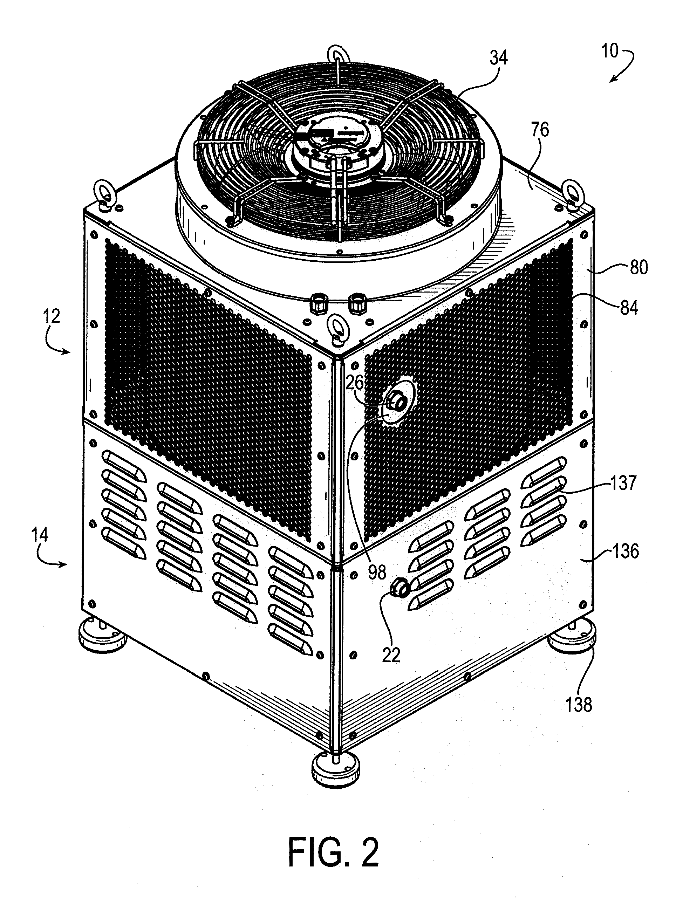

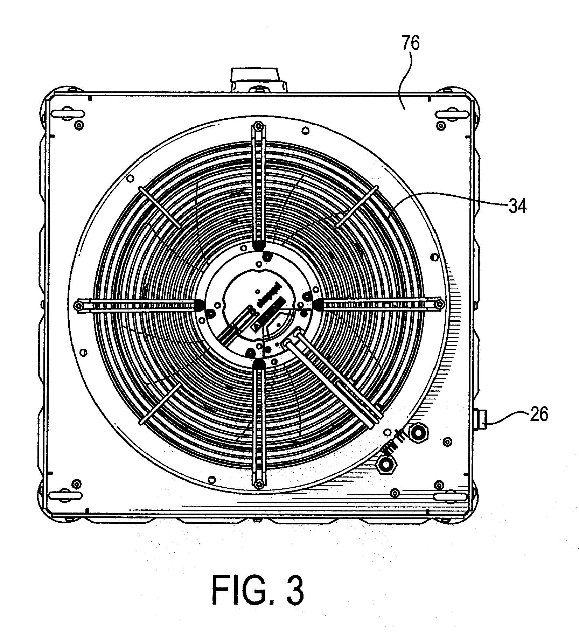

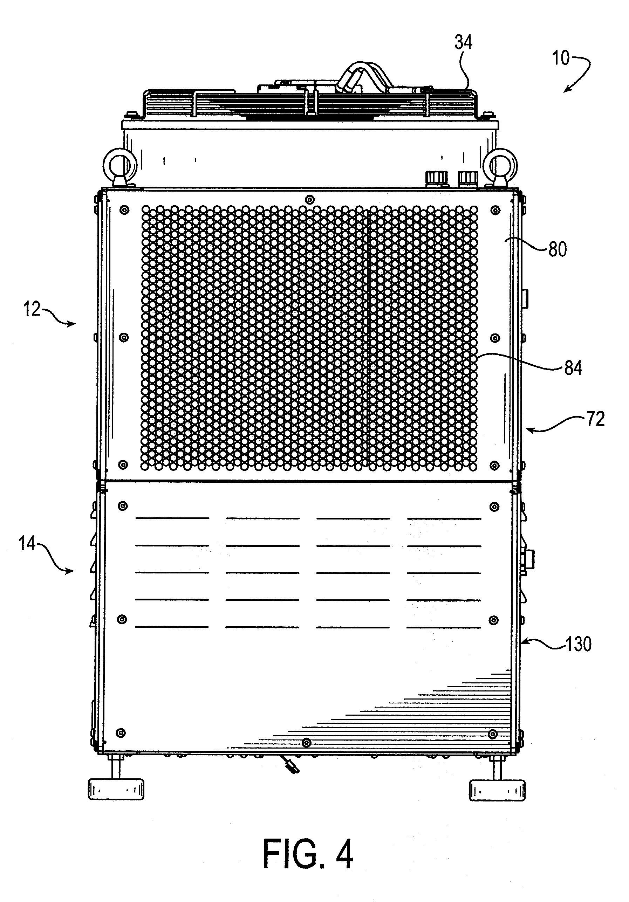

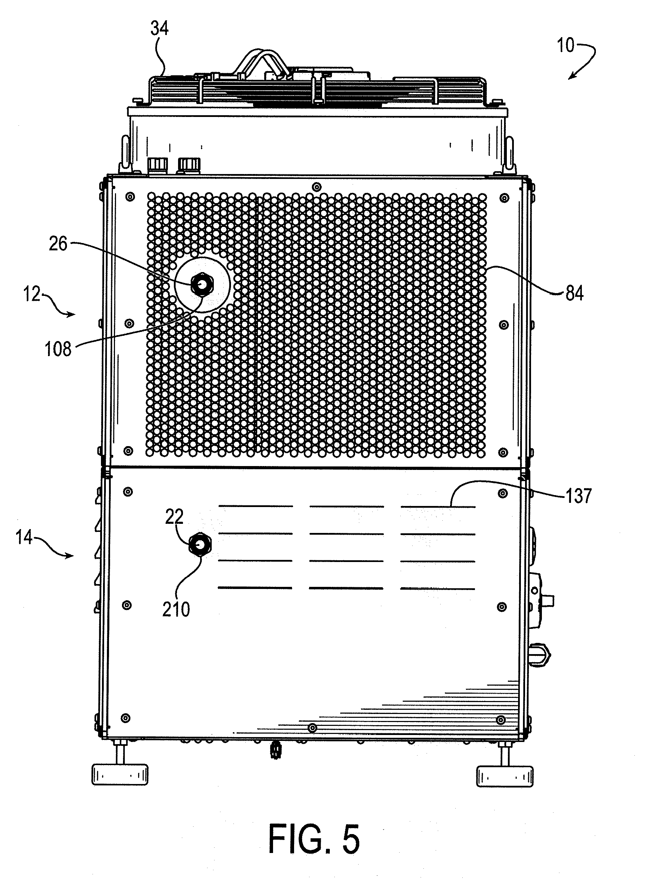

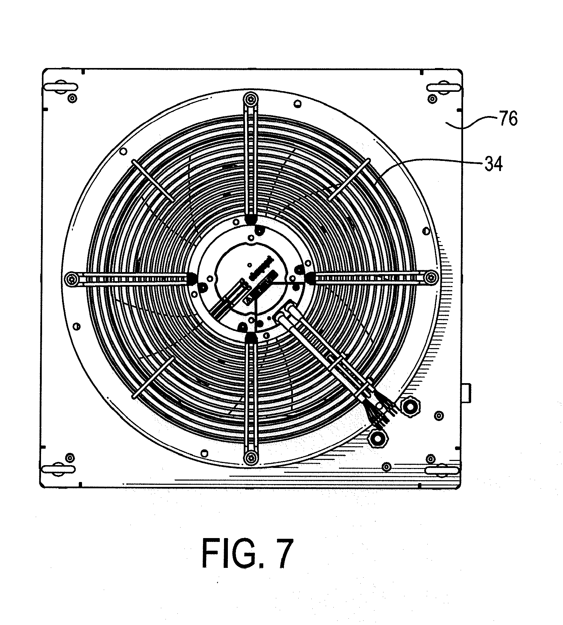

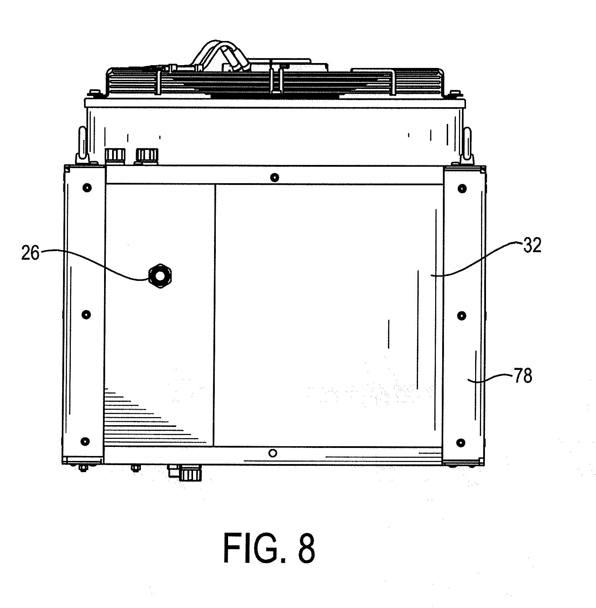

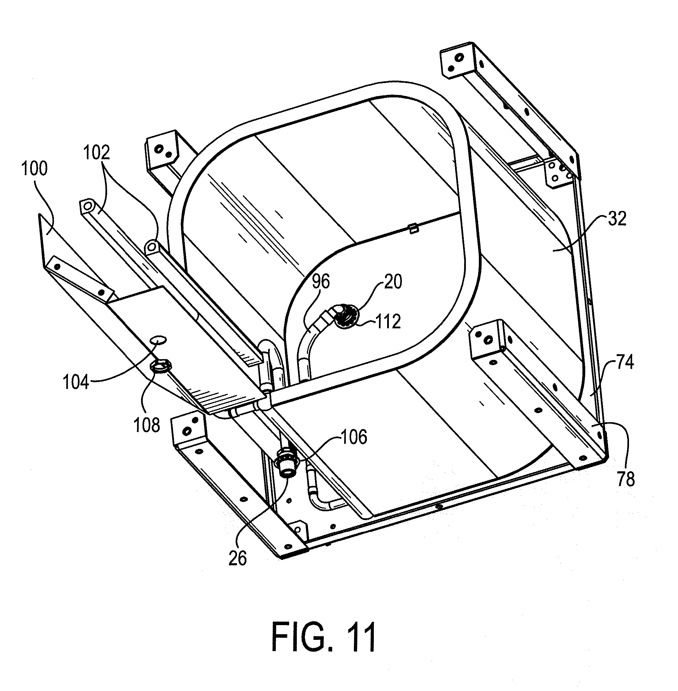

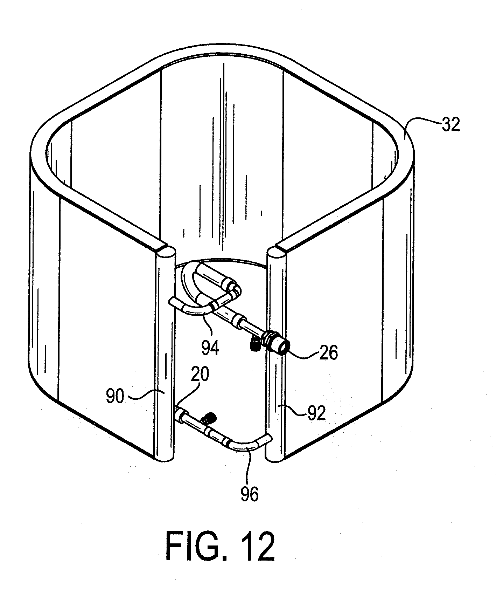

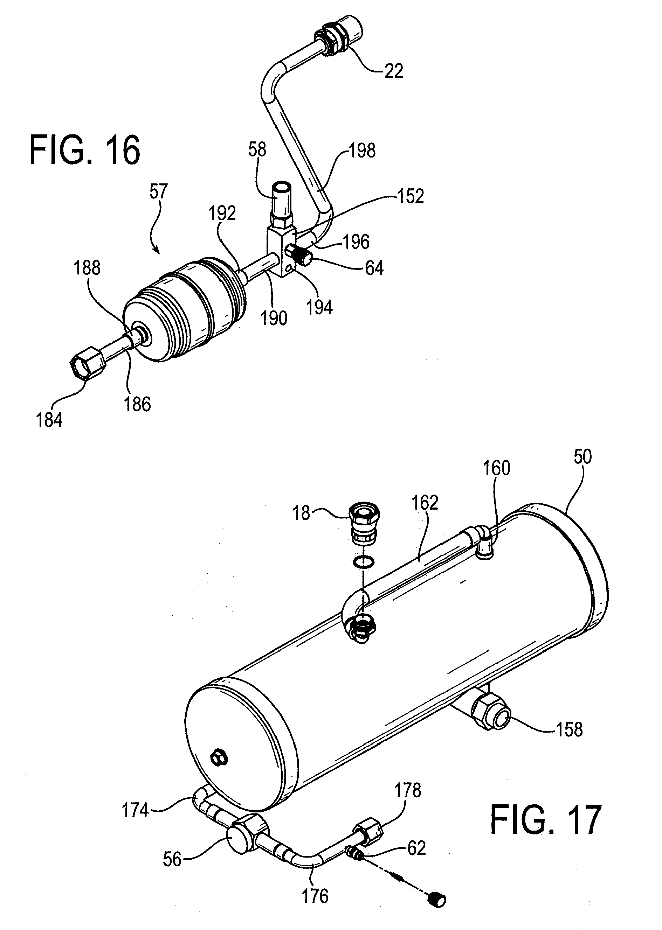

The cooling apparatus 10 is described in detail with reference to Figs. 2 to 17. Referring initially to Figs. 2 to 5, the cooling apparatus 10 is shown as a standalone unit separate from the heat sink 16. In this way, the cooling apparatus 10 can be coupled to any one of a plurality of heat sinks having different heat loads. The cooling apparatus 10 is therefore scalable to accommodate a wide range of cooling applications so that the apparatus does not have to be redesigned to accommodate a particular system.

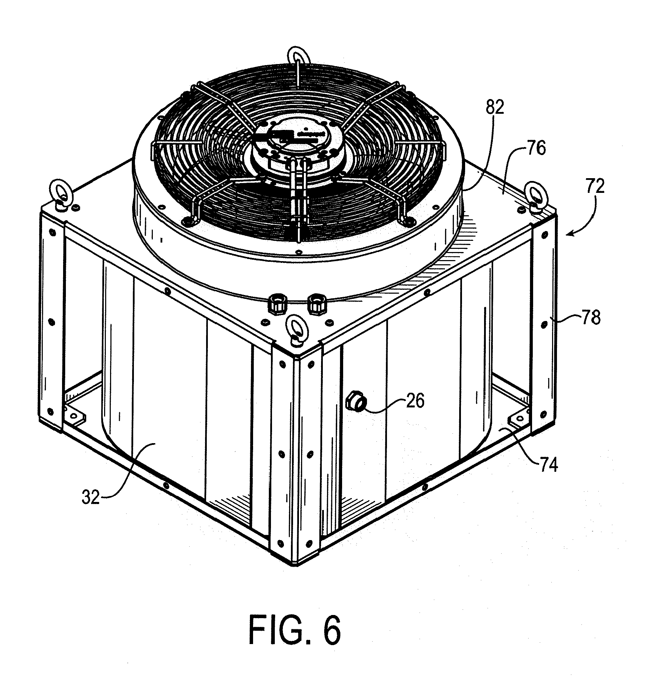

The cooling module 12 is described with reference to Figs. 6 to 12. It includes the condenser assembly 30, which may be a microchannel coil, and a housing 72 in which the condenser 32 and at least a portion of the fan 34 are disposed. The housing 72 includes a bottom portion 74, a top portion 76, a plurality of support portions 78 disposed between the top and bottom portions, and a plurality of side portions 80 (Fig. 2) extending between the support portions 78. The portions 74 to 80 can be coupled in any suitable manner, such as by suitable fasteners.

An opening 82 is provided in the top portion 76 through which the fan 34 extends. The fan 34 draws in air through the plurality of side portions 80, which may include perforations 84 (Fig. 2) for allowing the air into the housing 72, and blows the air over sides of the condenser 32. In the device shown in the drawings, the housing 72 is substantially rectangular in shape, and air is drawn into the four sides of the housing 72 and blown over the sides of the condenser 32, although the housing 72 may be any suitable shape.

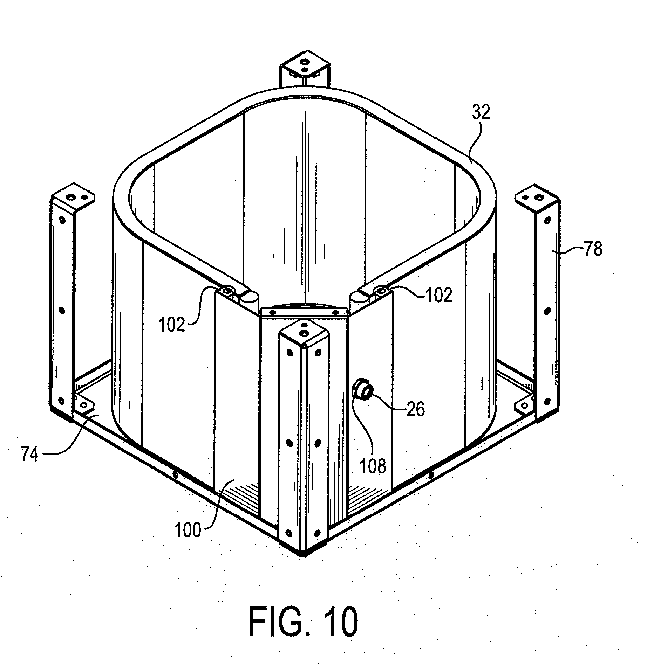

As best shown in Figs. 10 to 12, the condenser 32, which may be formed in any suitable shape, such as a substantially rectangular shape, is open at a corner at ends 90 and 92. Provided at the ends 90 and 92 are inlet and outlet conduits 94 and 96, although it will be appreciated that the conduits may be provided on the other of the ends or on both ends. Coupled to the inlet conduit 94 is the inlet coupling 26 and coupled to the outlet conduit 96 is the outlet coupling 20. The conduits may be coupled to the couplings in any suitable manner. An opening 98 (Fig. 2) is provided in one of the side portions 80 through which the inlet coupling 26 extends to allow for connection to a corresponding outlet coupling of the heat sink 16.

The inlet coupling 26 may be supported by a support plate 100 coupled to the bottom and top portions 74 and 76. The support plate 100 includes an opening 104 through which the inlet coupling 26 extends. Seals 102, such as foam rubber seams may be provided to prevent air from by-passing the condenser 32. A washer 106, such as a lock washer, and a nut 108 are connected to the coupling 26 on either side of the opening 104 to hold the coupling 26 and inlet conduit 94 in position.

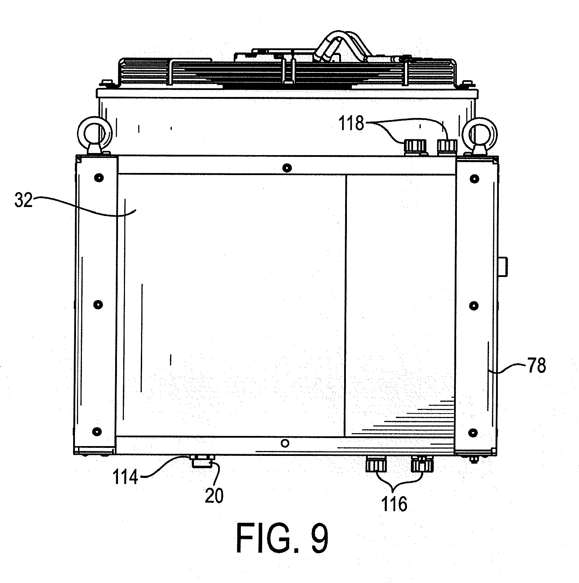

An opening is provided in the bottom portion 74 through which the outlet coupling 20 extends. A washer 112, such as a lock washer, and a nut 114 (Fig. 9) are coupled to the coupling 20 on either side of the opening to hold the coupling 20 in position. One or more openings may also be provided on the bottom and top portions 74 and 76 for electrical wiring. Extending through the openings are respective fittings 116 and 118 (Fig. 9) that are held in position by respective nuts. The fittings 118 may be provided for the electrical wiring of the fan 34 to extend through and the fittings 116 may be provided for the electrical wiring of the condenser 32 and fan 34 to extend through to a power box in the pumping module 14.

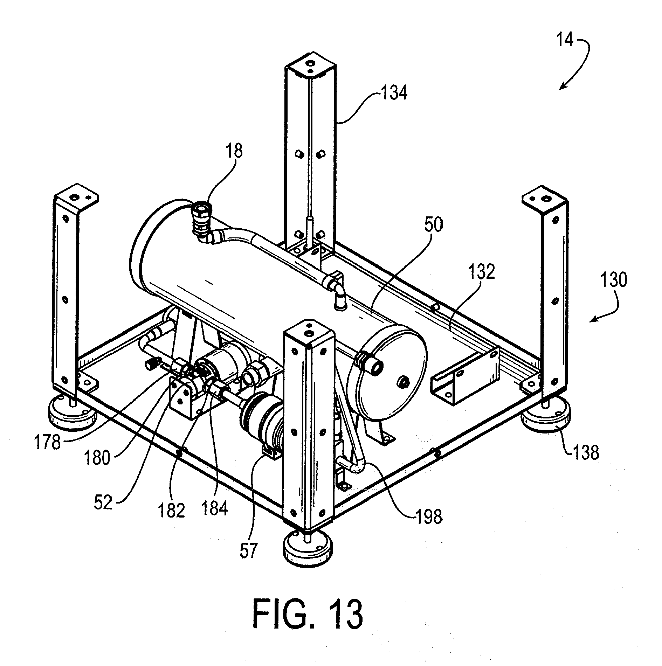

The pumping module 14 is described with reference to Figs. 13 to 17. It includes the reservoir 50, such as a liquid receiver configured to varying volumes of the liquid in the system, the pump 52, which may be any suitable pump such as a gear pump, and a housing 130 in which the reservoir 50 and the pump 52 are disposed. The housing 130 includes a bottom portion 132, a plurality of support portions 134 extending upward from the bottom portion 132, and a plurality of side portions 136 (Fig. 2) extending between the support portions 134. The side portions 136 may include one or more vents 137 (Fig. 2) for allowing air to escape the housing 130. The portions 132 to 136 may be coupled in any suitable manner, such as by suitable fasteners. Although a top portion is not shown, it will be appreciated that a top portion may be provided that couples to tops of the support portions 134. Provided at a bottom side of the bottom portion 132 are a plurality of feet 138 for leveling the apparatus 10 and for elevating the apparatus off the ground.

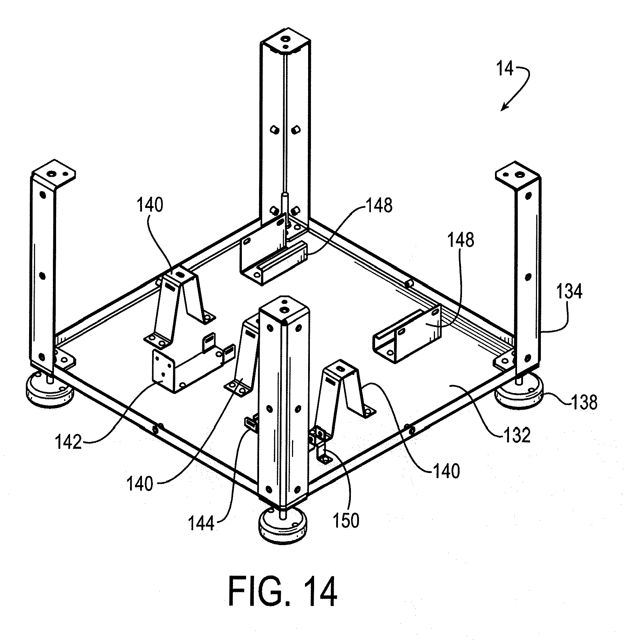

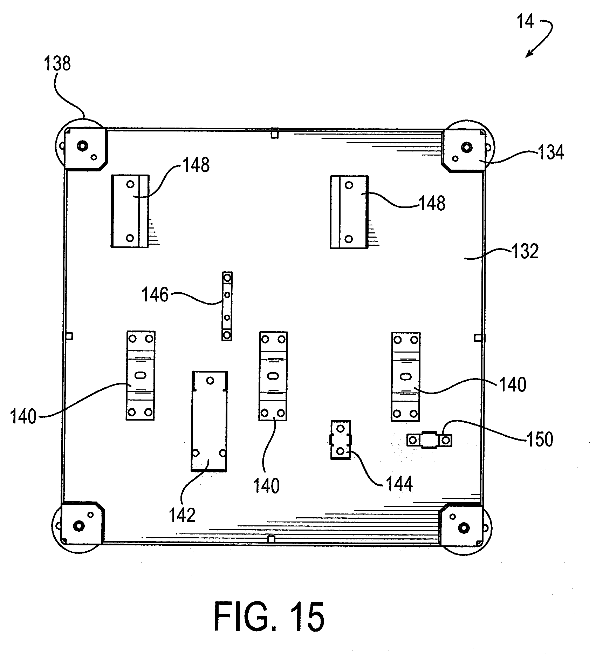

As best shown in Figs. 14 and 15, a plurality of brackets are coupled to the bottom portion 132 in any suitable manner, such as by suitable fasteners, for supporting the various components housed in the housing 130 and for coupling the components to the housing. For example, a plurality of brackets 140 are provided for coupling to the reservoir 50, a bracket 142 is provided for coupling to the pump 52, a bracket 144 is provided for coupling to the filter dryer 56, a bracket 146 is provided for coupling to the ball valve 66, brackets 148 are provided for coupling to an optional electrical enclosure (not shown), and bracket 150 is provided for coupling to a t-adaptor 152 that is coupled to the filter dryer 56 and the pressure relief valve 58.

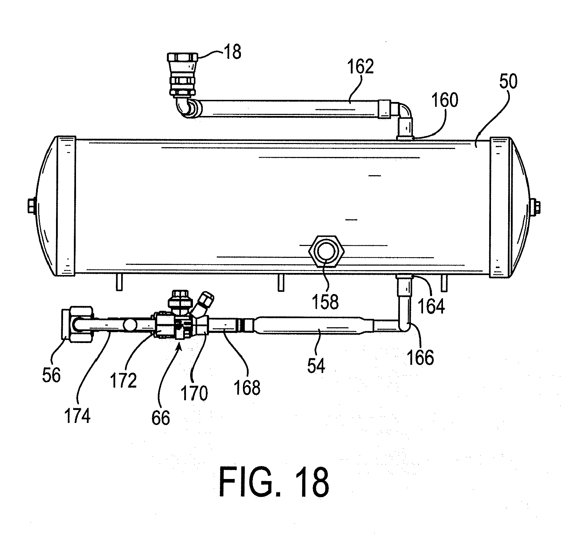

Referring now to Figs 13 and 16 to 18, the reservoir 50 includes a sight glass 158 for viewing the fluid in the reservoir, an inlet 160 coupled to an inlet conduit 162, and an outlet 164 coupled to an outlet conduit 166. The inlet conduit 162 is coupled to the inlet coupling 18, and the outlet conduit 166 is coupled to an end of the strainer 54. Coupled to another end of the strainer 54 is a conduit 168 that is coupled to an inlet 170 of the ball valve 66, and coupled to an outlet 172 of the ball valve 66 is a fluid conduit 174 coupled to an end of the sight glass 56. Coupled to another end of the sight glass is a conduit 176 that is coupled to an outlet coupling 178.

The output coupling 178 is coupled to an inlet coupling 180 of the pump 52 to deliver liquid from the reservoir to the pump. Coupled to an outlet coupling 182 of the pump is a coupling 184, which is coupled to a fluid conduit 186. The fluid conduit 186 is coupled to an inlet 188 of the filter dryer 57, and a fluid conduit 190 is coupled to an outlet 192 of the filter dryer 57. The outlet 192 of the filter dryer 57 is coupled to an inlet 194 of the pressure relief valve 58, and coupled to an outlet 196 of the pressure relief valve 58 is a fluid conduit 198. The fluid conduit 198 is coupled to the outlet coupling 22 that connects to the heat sink 16. The above described couplings may be any suitable couplings, such as male/female couplings that mate with one another automatically, and the components may be coupled in any suitable manner.

To allow the outlet coupling 22 to connect to a corresponding coupling connected to the heat sink 16, an opening is provided in one of the side portions 136 through which the outlet coupling 22 extends. A washer, such as a lock washer, and a nut 210 are connected to the coupling 22 on either side of the opening to hold the coupling 22 in position.

To assembly the pumped loop cooling apparatus 10, the cooling module 12 is placed on top of the pumping module 14 so that the outlet coupling 20 of the cooling module 12 mates with the corresponding input coupling 18 of the pumping module 14. When the cooling module 12 is on top of the pumping module 14, openings at the bottom of the bottom portion 74 and support portions 78 align with openings at the top of the support portions 134. Suitable fasteners may be inserted through the openings to couple the cooling module 12 to the pumping module 14. To facilitate this connection, the side portions 80 and/or side portions 136 can be removed to allow access to the supports 78 and 134. By positioning the condenser 32 above the reservoir 50 and pump 52, the condenser is prevented from being flooded with liquid, and allows gravity to assist with liquid/vapor separation.

During operation, fluid is directed through the heat sink 16, and the fluid boils to a part liquid and part vapor mixture as it absorbs heat from the heat source. The two-phase fluid mixture then flows to the cooling apparatus 10, where it enters the cooling module 12 via the inlet coupling 26. The mixture flows through the coupling 26 to the fluid conduit 94, where it enters the condenser 32. As the mixture flows through the condenser 32, the fan 34 draws air into the housing 72 through the perforations 84 in the side portions 80 so that the air flows across the condenser 32 cooling the mixture. The condenser 32 then condenses the mixture to a sub-cooled liquid and the fan 34 rejects the heat to the environment.

The liquid then exits the condenser 32 through the fluid conduit 96 and flows to the outlet coupling 20 coupled to the inlet coupling 18 of the pumping module 14. The liquid flows through the couplings 18 and 20 to the fluid conduit 162 and then into the reservoir 50, which acts as a storage tank to compensate for varying volumes of the liquid in the system 8. The liquid then exits the reservoir 50 through the fluid conduit 166 and flows to the strainer 54 where it is filtered. The fluid exits the strainer 54 and flows through the fluid conduit 168 and through the ball valve 66 when the valve is open. The fluid flows through the valve to the fluid conduit 174, flows through the sight glass 56 to the fluid conduit 176, and then flows through the conduit 176 and coupling 178 to the inlet coupling 180 of the pump 52. The pump then directs the liquid through the outlet coupling 182 coupled to the coupling 184 and then through the fluid conduit 186 to the filter dryer 57 that removes moisture. The fluid exits the filter dryer 57 and flows through the fluid conduit 190, through the t-adaptor 152, and then through the fluid conduit 198 to the outlet coupling 22 that is coupled to the heat sink 16 to provide the liquid to the heat sink for cooling.

## Claims

1. A modular pumped loop cooling apparatus including:
a cooling module that rejects heat absorbed by a two-phase fluid entering the cooling module and that condenses the two-phase fluid to a liquid, and
a pumping module that receives the liquid from the cooling module and pumps the liquid to a heat sink,
wherein the pumping module has an inlet coupling for mating with a corresponding outlet coupling of the cooling module when the cooling module is placed on top of the pumping module.

2. The pumped loop apparatus according to claim 1, wherein the couplings mate with one another automatically during placement of the cooling module on top of the pumping module.

3. The pumped loop apparatus according to claim 1 or claim 2, wherein the cooling module includes an inlet portion for connecting to the heat sink and the pumping module includes an outlet portion for connecting to the heat sink.

4. The pumped loop apparatus according to claim 3, wherein the cooling module defines a cooling portion of a loop and the pumping module defines a pumping portion of the loop, and wherein the loop is completed by the heat sink.

5. The pumped loop apparatus according to any one of claims 1 to 4, wherein the cooling module includes a housing and a condenser assembly disposed in the housing, the condenser assembly including an inlet conduit and an inlet coupling for connecting to the heat sink and an outlet conduit and the outlet coupling.

6. The pumped loop apparatus according to claim 5, wherein the pumping module includes a reservoir having an inlet conduit and the inlet coupling that mates with the outlet coupling of the cooling module, a pump fluidically coupled to the reservoir and including an outlet conduit and an outlet coupling for connecting to the heat sink, and a housing that houses the reservoir and the pump.

7. The pumped loop cooling apparatus according to claim 6, wherein the housing has a base portion, a plurality of support portions extending from the base portion, and a plurality of side portions coupled to the support portions, and wherein a plurality of brackets are coupled to the base portion for supporting the reservoir and the pump.

8. The pumped loop cooling apparatus according to claim 7, wherein one of the plurality of side portions includes an opening through which the outlet coupling coupled to the pump outlet conduit extends.

9. The pumped loop cooling apparatus according to any one of claims 5 to 8, wherein the condenser assembly includes a condenser that condenses the two-phase fluid and a fan that rejects the heat.

10. The pumped loop cooling apparatus according to claim 9, wherein the fan extends through an opening in the housing on top of the housing and is configured to draw air into a plurality of sides of the housing to cool the two-phase fluid in the condenser and reject the heat to an environment outside of the housing.

11. The pumped loop cooling apparatus according to claim 10, wherein the plurality of sides of the housing have perforations for allowing the air to be drawn into the housing and blown over corresponding sides of the condenser.

12. The pumped loop cooling apparatus according to claim 11, wherein one of the plurality of side portions includes an opening through which the inlet coupling of the condenser assembly extends.

13. The pumped loop cooling apparatus according to any one of claims 5 to 8, wherein the condenser assembly includes a condenser that condenses the two-phase fluid and a liquid cooling assembly for passing liquid across the condenser to cool the fluid.

14. The pumped loop cooling apparatus according to any one of claims 1 to 13 in combination with any one of a plurality of heat sinks having different heat loads and being configured to be in thermal contact with a heat source, wherein the cooling module includes an inlet portion connected to one of the plurality of heat sinks and the pumping module includes an outlet portion connected to one of the plurality of heat sink.

15. A method of assembling a pumped loop cooling apparatus including:
providing a cooling module having an input mating coupling for connecting to a first mating coupling on any one of a plurality of heat sinks having different heat loads,
providing a pumping module having an output mating coupling for connecting to a second mating coupling on any one of the plurality of heat sinks, and
placing the cooling module on top of the pumping module such that an output mating coupling of the cooling module mates with a corresponding input mating coupling of the pumping module to fluidly couple the cooling module and the pumping module.
